# EUROPEAN PATENT APPLICATION

(11) **EP 4 489 149 A1**
(43) Date of publication of application: **08.01.2025**
(21) Application number: 23763720.2
(22) Date of filing: 03.03.2023
(51) Int. Cl.: H01M 8/04089, H01J 1/304, H01J 27/02, H01J 37/08

(54) **HYDROGEN ACTIVATION/IONIZATION ACCELERATOR HAVING IONIZATION REGION REPEATING ARRANGEMENT STRUCTURE**

(30) Priority: 03.03.2022 KR 20220027566; 29.11.2022 KR 20220163380
(71) Applicant: Shin, Sang Yong, Seoul 06642 (KR); Vach, Young Woo, Wonju-Si Gangwon-do 26388 (KR); Shin, Jaeun, Seoul 06642 (KR)
(72) Inventor: Shin, Sang Yong, Seoul 06642 (KR); Vach, Young Woo, Wonju-Si Gangwon-do 26388 (KR); Shin, Jaeun, Seoul 06642 (KR)
(74) Representative: Verscht, Thomas Kurt Albert
(86) International application number: PCT/KR2023/002903
(87) International publication number: WO 2023/167522

(57) **Abstract**

The present invention is installed between a hydrogen fuel cell and a hydrogen supply device, wherein hydrogen supplied to the hydrogen fuel cell is activated by the strength of an ultra-high density line electric field and supplied in a high energy state to a hydrogen fuel cell stack, so as to serve as a turbo/accelerator that can generate large amounts of electricity by increasing bonding rates between hydrogen and oxygen through improvement of activation/ionization rates with low energy in an ionization layer catalyst of the hydrogen fuel cell.

## Description

### Technical Field

The apparatus according to present invention is installed between a hydrogen fuel cell stack and a hydrogen supply device, and activates hydrogen to a high energy level using a high density electric flux before the hydrogen is supplied to the hydrogen fuel cell stack. Then, hydrogen activated/ionized by field electron emission is supplied, and ionization is repeatedly performed with high efficiency with only a small amount of energy absorption within the ionosphere of the hydrogen fuel cell. The present invention relates to an apparatus that promotes physical auxiliary activation/ionization and plays a turbo/acceleration role in the electricity generation process of the hydrogen fuel cell to generate a large amount of electricity with higher efficiency.

### Background Art

In the past 10 years, energy consumption in Korea has been increasing by more than 10% annually. Greenhouse gas emissions increase in proportion to the increase in energy consumption. Currently, research and development on new renewable energy that can reduce greenhouse gas emissions is actively being conducted worldwide, and considering various applications and application aspects, this development can play a leading role. Among the new renewable energies being actively developed, it is expected to be applied to turbo/accelerator devices for hydrogen fuel cells, solar thermal energy, and various forms of alternative energy. In particular, hydrogen energy has the potential to obtain hydrogen by electrolyzing water, which exists infinitely, and can be produced by reacting it with air to produce energy, and can be produced in various ways such as methane and natural gas separation, and it does not produce pollutants, and furthermore, it does not produce noise when producing energy, has a higher energy production efficiency than other types, and is widely applied to various types of electricity generation equipment, etc., and thus, it is receiving more attention than other new renewable energies. And hydrogen and oxygen, the basic materials of hydrogen fuel cells, are the most abundant elements on Earth. Accordingly, among other new renewable energies, hydrogen in particular has almost completely analyzed physical properties, so more diverse research is being conducted in depth.

However, most hydrogen fuel cells and devices connected to them developed to date have limitations in converting hydrogen energy into electrical energy with higher efficiency than the function of existing hydrogen fuel cells, and there is a problem that the operating temperature of existing hydrogen fuel cells is high. In addition, there is a limit to the mass amplification of hydrogen ionized/activated by catalytic action in the existing hydrogen fuel cell ionosphere, and thus there is a problem in that the efficiency cannot be maximized.

(Patent Document 1) Republic of Korea Registered Patent No. 10-2200739 (Publication Date: January 12, 2021)

### Disclosure

### Technical Problem

The problem to be solved by the present invention is that, before hydrogen used in a hydrogen fuel cell is ionized (2H⁺ + 2e) in the electrolyte of the cell, some of the hydrogen is activated (H₂*) from various catalysts and the majority is not activated, so that the overall ionization rate of electricity generation is low, resulting in a low power generation efficiency, thereby solving the problem of a low electricity generation rate in a hydrogen fuel cell. In addition, the present invention aims to solve the problem that the economic feasibility of a hydrogen fuel cell is not high under various conditions including the hydrogen production process. That is, the purpose of the present invention is to induce a highly efficient electricity production method by maximally activating hydrogen gas and simultaneously increasing the ionization rate.

The problems to be solved by the present invention are not limited to the problems mentioned above, and other technical problems not mentioned will be clearly understood by those skilled in the art from the description below.

### Technical Solution

In order to achieve the above technical task, the hydrogen activation/ionization accelerating apparatus having a repeating array structure of an ionization unit of the present invention is a structure installed between a hydrogen supply device (A) and a hydrogen fuel cell (B), and an ultra-high density electric flux formed inside thereof simultaneously generates/amplifies hydrogen gas by ionization (2H⁺+2e)/activation (H₂*) and then injects it into the hydrogen fuel cell, thereby ionizing the function of the basic hydrogen fuel cell more smoothly and generating a high electricity generation rate.

Such ionization units are hydrogen activation/ionization accelerators with a negative/positive repeating array structure, including various shapes of metal pin types with sharp ends, vortex blade shapes, rods with multiple blades wound in a vortex, and composite vortex types of wires between blades.

The present invention comprises, a case (10) in which an accommodation space (100) is formed inside, a gas inlet tube (111) is formed at one end to be connected to the accommodation space (100) and a hydrogen supply device (A), and a gas discharge tube (121) is formed at the other end to be connected to the accommodation space (100) and a hydrogen fuel cell (B); activation/ionization rods(Hereinafter, ionization rods) comprising a support (210) and a sharp metal (220) formed on the outer surface of the support (210); ionization cylinders (30) formed in a cylindrical shape and accommodating ionization rods (20) inside; a brass fixing unit (40) comprising: a first anode plate (412) that comprises a plurality of rod fixing holes (4110), fixes one end of the support (210) protruding outward from one end of the ionization cylinder portion, and is connected to the positive electrode of the power supply so that the ionization rod portion (20) has a bipolar shape, and a first cathode plate (411) that comprises a plurality of cylinder fixing holes (4120), and fixes one end of an ionization cylinder (30) to each cylinder fixing hole (4120) and is connected to a negative electrode of a power supply so that the ionization cylinder (30) has a negative polarity; and a gasket (50) comprising a receiving hole (500) formed inside and interposed between the first anode plate (412) and the first cathode plate (411). The brass fixing unit (40) further comprises a second anode plate (422) that fixes the other end of the support module (210) protruding outward from the other end of the ionization cylinder, and a second cathode plate (421) that comprises a plurality of cylinder fixing holes (4120) and fixes the other end of the ionization cylinder (30) to each of the cylinder fixing holes (4120).

Furthermore, the hydrogen activation/ionization accelerating apparatus having an ionization unit repeating arrangement structure according to the present invention is connected to an auxiliary battery unit (11) that is connected at one end to the first anode plate (412) and at the other end to the first cathode plate (411), and is charged with electricity supplied through the first anode plate (412) and the first cathode plate (411). And, the case (10) comprises a cover unit (110) comprising the gas inlet tube (111) with an inlet screw module (1111) installed inside, and a body unit (120) in which the gas discharge tube (121) is formed.

### Advantageous Effects

The present invention increases the activation energy of hydrogen by repeatedly activating/ionizing hydrogen multiple times, thereby supplying ionized hydrogen (2H⁺+2e) and hydrogen with high activation energy (H₂*) to a hydrogen fuel cell, thereby enabling a large amount of electricity to be generated from the hydrogen fuel cell. In addition, the present invention combines a large amount of electricity generated in the process of activating and ionizing hydrogen multiple times with electricity generated from a conventional hydrogen fuel cell or charges an auxiliary battery, and ionizes hydrogen by using the auxiliary battery as a power source when an external power source is not supplied.

That is, the present invention can increase the electricity generation rate by amplifying the ionization (2H⁺+2e) and activated hydrogen (H₂*) of hydrogen multiple times. That is, the present invention generates electricity in the process of repeatedly increasing the ionization (2H⁺+2e) and activation (H₂*) energy of hydrogen, and then repeatedly increases the activation energy of hydrogen by ionizing hydrogen again with the generated electricity.

Here, the structure of the metal ionization unit is that when a negative/positive direct current voltage is applied, the electric field strength of the ultra-high-density electric field flux around the sharp surface easily activates hydrogen to an energy level close to ionization, increasing it to -1.5 to 0.0 eV. Then, the activated hydrogen is moved to the existing hydrogen fuel cell stack, and in the hydrogen fuel cell stack, the activated hydrogen in the ionosphere receives a small energy of -1.5 eV or more from the catalyst, and ionizes the activated hydrogen while releasing electrons directly. At this time, when the ionization energy of hydrogen of 13.6 eV or more from the metal ionization is applied, the current generated by ionization joins the electricity generated in the existing hydrogen fuel cell stack. At this time, the binding energy required to ionize the ground state electrons in hydrogen atoms is -13.6 eV (1 eV = 1.60 x 10 -19 joule).

Moreover, the present invention uses the field emission electron method, which is the most efficient method for extracting electrons from metals or semiconductors. In addition, the present invention improves the electricity generation efficiency of hydrogen fuel cells by activating and ionizing hydrogen by a physical method without using a chemical method, and can easily extract electrons. At this time, the dynamics of applying the activation of hydrogen and the ionization of hydrogen simultaneously can be the most important electrostatic dynamics for the electricity generation of the hydrogen fuel cell stack. The present invention, which generates an electrostatic role, can be used semi-permanently because all the substances and materials in its internal configuration physically interact with pure (99.99999%) hydrogen gas, and there is no corrosion/wear, etc.

The present invention, which has such features, is not limited to fuel cells for passenger cars, but can be applied to construction machinery and ships, such as forklifts, excavators, and internal generators for yachts, drones, salvage ships, and passenger ships, to improve the performance of fuel cells. In other words, the present invention is viewed as an amplification (turbo)/acceleration device that can be applied to various equipment using hydrogen cells to improve the performance and efficiency of hydrogen cells.

### Description of Drawings

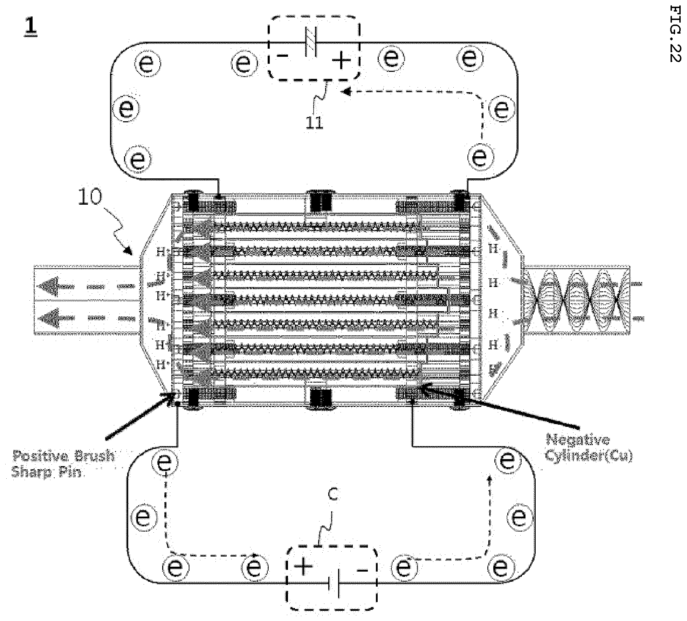

FIG. 1 is a block diagram showing the state of use of a hydrogen activation/ionization accelerating apparatus having an ionization unit repeating arrangement structure according to one embodiment of the present invention.
FIG. 2 is a perspective view of the overall appearance of a hydrogen activation/ionization accelerating apparatus having the ionization unit repeating arrangement structure of FIG. 1.
FIG. 3 is an exploded perspective view of the entire system of a hydrogen activation/ionization accelerating apparatus having the ionization unit repeating arrangement structure of FIG. 2. FIG. 4 is a drawing showing the first to fourth type ionization units of various sharp vortex shapes of FIG. 3.
FIGS. 5 and 6 are drawings specifically showing the combination of the sharp blade surface and the round copper wire of the first to fourth type ionization units shown in FIG. 4.
FIG. 7 is a drawing showing the second anode plate, the second gasket, and the second cathode plate of FIG. 1.
FIG. 8 is a drawing showing a state in which the second anode plate, the second gasket, and the second cathode plate of FIG. 7 are combined.
FIG. 9 and FIG. 10 are drawings showing a state in which a first type of ionization rods, a second type of ionization rods, a third type of ionization rods, and a fourth type of ionization rods are fixed to the second anode plate, the second gasket, and the second cathode plate, and the speed at which hydrogen enters (V).
FIGS. 11 and 12 are drawings of the structure shown in FIGS. 9 and 10 viewed from the right side. Here, the metal ionization unit may be combined in a form in which the center is high and the outside is low.
FIG. 13 is a drawing showing a state in which the ionization rod and the ionization cylinder (brush) of the first type are fixed to the brass fixing unit and the gasket unit, and an enlarged drawing is a drawing showing a part of the high-density electric field flux formed between the ionization unit and the cylinder.
FIG. 14 shows a state where the third type ionization rod and the ionization cylinder are fixed to the brass fixing unit and the gasket unit, and the enlarged figure is a drawing showing part of the high-density electric field flux formed between the ionization rod (the sharp part of the three-layer vortex blade) and the cylinder.
FIG. 15 is a drawing showing a state where the ionization rod and the ionization cylinder of the fourth type are fixed to the brass fixing unit and the gasket unit, and an enlarged drawing showing the high-density electric field flux formed between the fourth type ionization unit (the ionization unit in which a round wire is inserted between sharp screws of vortex-type blades) and the cylinder. Here, since the round wire is inserted between the blades, the electric field flux is focused to a sharp surface, thereby inducing a higher electric field intensity.
FIG. 16 is a drawing showing a state in which the first type ionization rod and the ionization cylinder are fixed to the second anode plate, the second gasket unit, and the second cathode plate of FIG. 8, and the cylinder fixing part is fixed to the ionization cylinder.
FIG. 17 is a drawing showing a state in which the first gasket unit is connected to FIG. 16 and the first anode plate are connected to the cylinder fixing bolt unit and the brass fixing unit.
FIG. 18 is a cross-sectional view taken along line I-I' of a hydrogen activation/ionization accelerating apparatus having a repeating arrangement structure of ionization units having various sharp surfaces (first, second, third, and fourth metal ionization units) according to one embodiment of the present invention of FIG. 2.
FIGS. 19 to 24 are drawings showing the principle of activating/ionizing hydrogen in a hydrogen activation/ionization accelerating apparatus having a repeating arrangement structure of various types of ionization units.

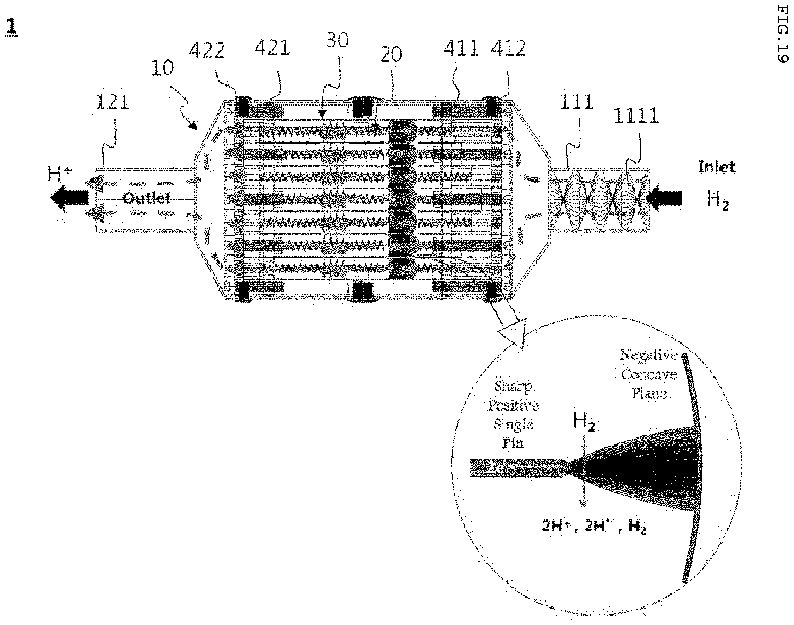

FIG. 19 is a diagram showing the mechanism by which a repeating array of bipolar vortex-type metal brush pins activates/ionizes/neutralizes electrons in a cathode copper cylinder and the phenomenon of generating electricity through repeated activation/ionization/neutralization between an electric field and hydrogen in a passage.

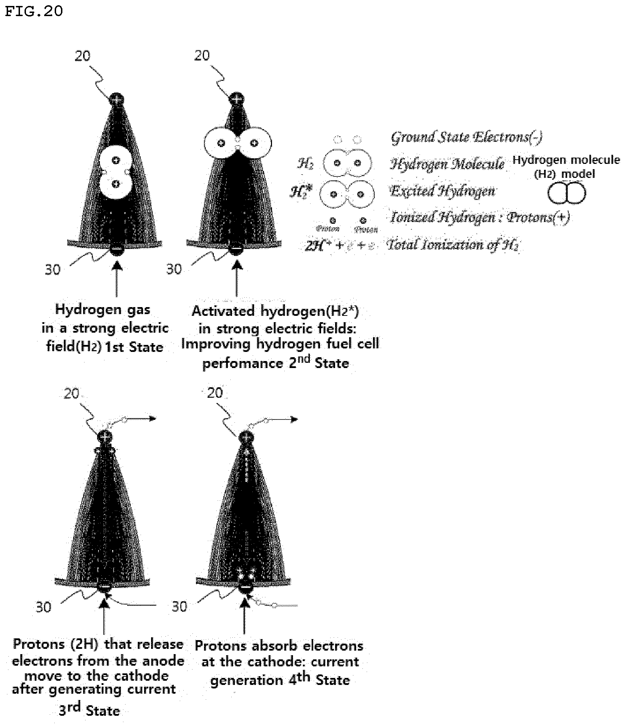

FIG. 20 is a diagram showing a state in which electricity is repeatedly generated and superimposed N times while hydrogen is activated (H₂*: 2nd State) by a strong high-density electric field flux distribution (1st State) and electric field intensity at one point of a repeating array structure of a cathode brush pin cathode copper cylinder ionization section according to an embodiment of the present invention, ionized (3rd State) at the anode, electrons are emitted, and as the positive charge of the anode hydrogen (2H+: Proton) moves to the strong cathode, electrons are easily absorbed by copper, which has lower ionization energy than hydrogen (4th State: Field Emission Electron), and become neutral.

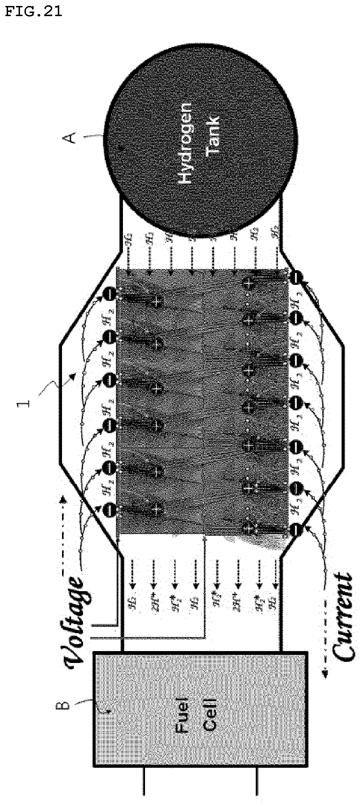

FIG. 21 is a diagram of a process in which hydrogen (H₂) supplied from a hydrogen supply device (A) is transformed into Excited State (H₂*) → Ionized (2H⁺+2e) → Neutralized (H₂) by a strong negative/positive electric field flux formed between the triple vortex blade tips of activation/ionization units and a copper cylinder, thereby repeatedly generating electricity by extracting electrons (Field Emission Electrons) from hydrogen (H₂).
As shown in Fig. 22, hydrogen gas (H₂) continuously supplied from a hydrogen supply device (A) is repeatedly transformed into Excited State (H₂*) → Ionized (2H⁺+2e) → Neutralized (H₂) in a strong negative/positive high-density electric field flux and supplied to a hydrogen fuel cell stack (B), so that a large amount of electricity can be produced in the hydrogen fuel cell stack (B). In addition, a portion of the produced electricity is stored in an auxiliary battery (50). Here, the Excited State (H₂*) means hydrogen in a state in which the activation energy is high due to the attraction/repulsion of the electric field and which is easily ionized. This hydrogen becomes a process that increases the efficiency of electricity generation of the hydrogen fuel cell stack.

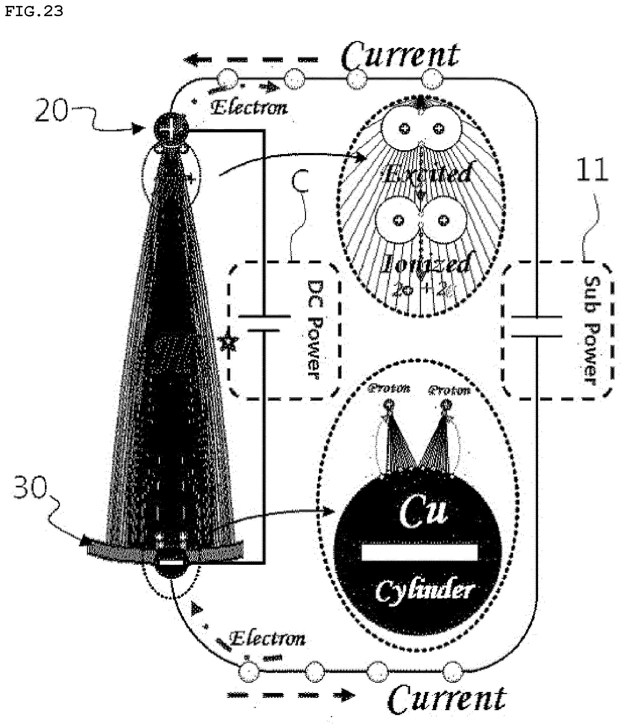

FIG. 23 is a drawing specifically illustrating a process in which hydrogen is activated and cationized at one point of a hydrogen activation/ionization accelerating apparatus having a repeating arrangement structure of an ionization units consisting of a positive brush pin and a negative copper cylinder, and the cationized hydrogen, i.e., protons, are neutralized by absorbing electrons (field emission electrons) from a copper cylinder having low ionization energy, thereby repeatedly generating electricity, and a portion of the generated electricity is joined to a current generated from an existing hydrogen fuel cell stack or charges an auxiliary battery section.

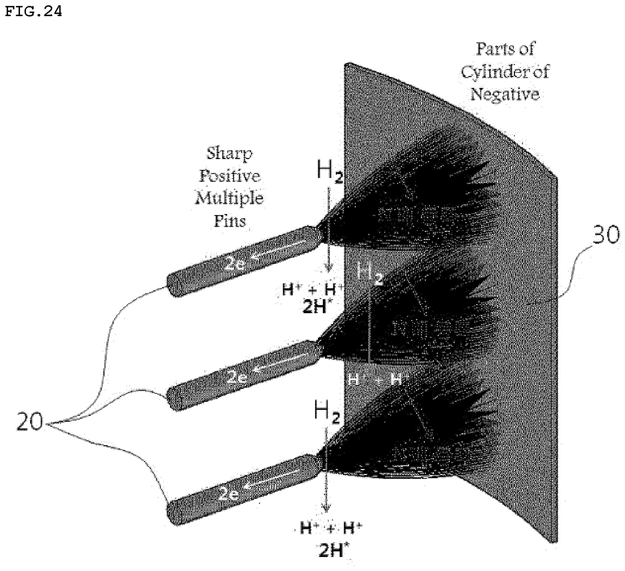

Figure 24 is a figure showing a phenomenon in which hydrogen gas undergoes a continuous cycle of "activation → ionization → neutralization → activation → ionization" due to a high-density electric field flux formed between a positive metal brush pin (type 1 ionization rod) and a negative copper cylinder, thereby generating an electric current.

### Best Mode

The invention will become clearer through the description with the accompanying drawings, and the advantages and features of the embodiments of the invention. However, the invention, which becomes clearer through the drawings and description, is not limited to the embodiments disclosed below. The invention is defined solely by the claims and is limited according to the contents set forth in the claims.

Hereinafter, the present invention will be described in detail with reference to the attached drawings so that a person skilled in the art to which the present invention pertains can fully understand the present invention.

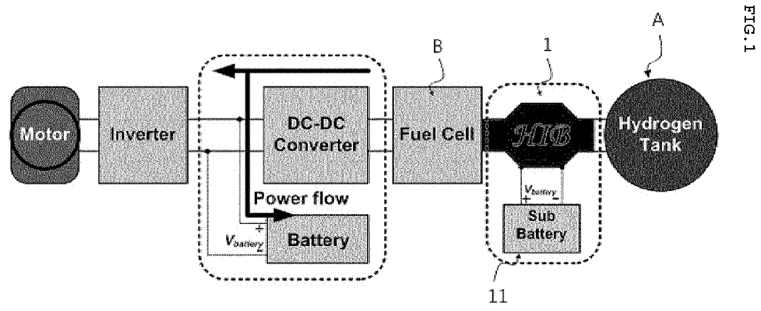

First, referring to FIG. 1, a hydrogen activation/ionization accelerating apparatus (1) having a repeating arrangement structure of ionization units in the form of sharp various blades according to one embodiment of the present invention will be generally described.

FIG. 1 is a block diagram showing a state in which a hydrogen activation/ionization accelerating apparatus (1) having a variety of ionization unit repeating arrangement structures according to one embodiment of the present invention is used in an existing hydrogen fuel cell system.

A hydrogen activation/ionization accelerating apparatus (1) having a structure of a repeating arrangement of ionization units of various sharp shapes repeatedly activates/ionizes hydrogen supplied from an existing hydrogen supply device (B) multiple times when passing through the activation/ionization accelerator (1), thereby increasing the overall activation energy of hydrogen and supplying it to a hydrogen fuel cell (B), thereby enabling a large amount of electricity to be generated/amplified in the hydrogen fuel cell (B). The electricity generated by ionization here is joined to the electricity generated by the existing hydrogen fuel cell or is separately charged to an auxiliary battery (11) and reused when necessary.

In addition, the hydrogen activation/ionization accelerating apparatus (1) having various ionization unit repeating arrangement structures accumulates electrons generated in the process of activating/ionizing hydrogen multiple times with a strong high-density electric field flux, so that they can be used in situations where electricity is needed.

In this way, the present invention repeatedly ionizes hydrogen and increases the activation energy of hydrogen, thereby enabling a fast and high chemical reaction between hydrogen and oxygen in an existing hydrogen fuel cell. In other words, the hydrogen activation/ionization accelerating apparatus (1) having various sharp ionization units having a repeated arrangement structure repeatedly amplifies the ionization (2H⁺+2e), activated hydrogen (H₂*), and neutralization (H₂) of hydrogen and supplies them to the hydrogen fuel cell (B), thereby increasing the electricity generation rate of the hydrogen fuel cell (B). The hydrogen activation/ionization accelerating apparatus (1) having various sharp metal blade-shaped ionization units having a repeated arrangement structure is not limited to fuel cells for passenger cars, but can be applied to construction machinery and ships, such as forklifts, drones, excavators, and internal generators of yachts, salvage ships, and passenger ships, thereby improving the performance of the fuel cell.

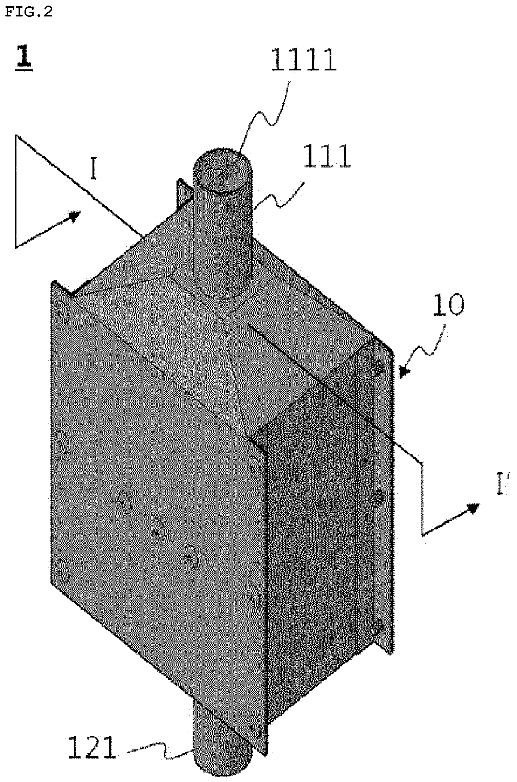

Accordingly, the present invention can solve the problem of the current hydrogen fuel cell (B) not being able to sufficiently generate electricity with the highest efficiency due to limited activation/ionization compared to the amount of hydrogen supplied, that is, the problem of low electricity generation rate. Hereinafter, referring to FIGS. 2 to 7, the elements constituting the hydrogen activation/ionization accelerating apparatus having an ionization unit repeating arrangement structure and the basic structure for generating a high-density electric field flux in a blade shape or pin shape, etc. will be described in detail.

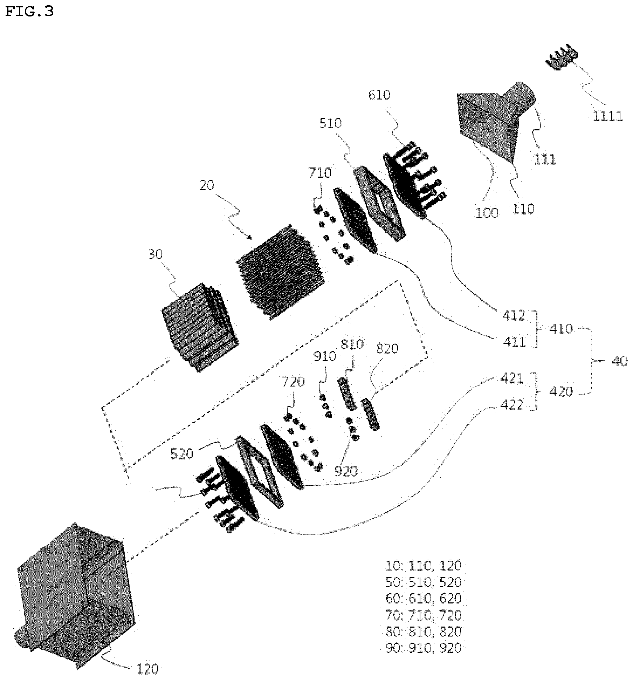

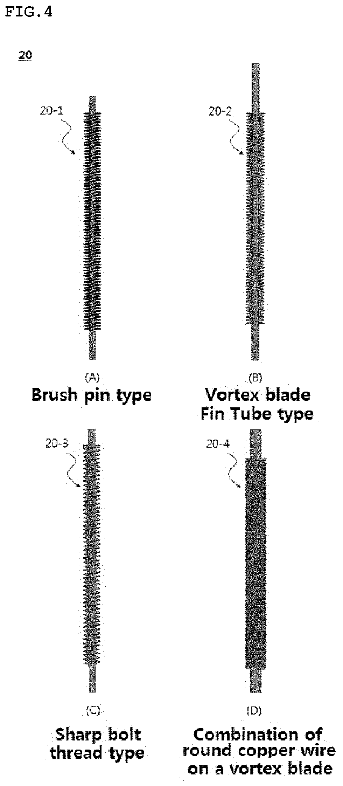

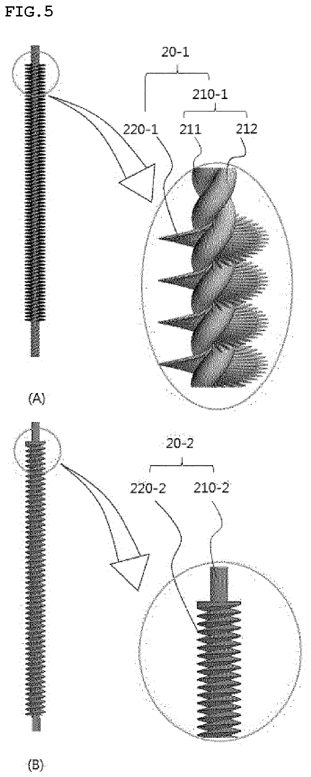

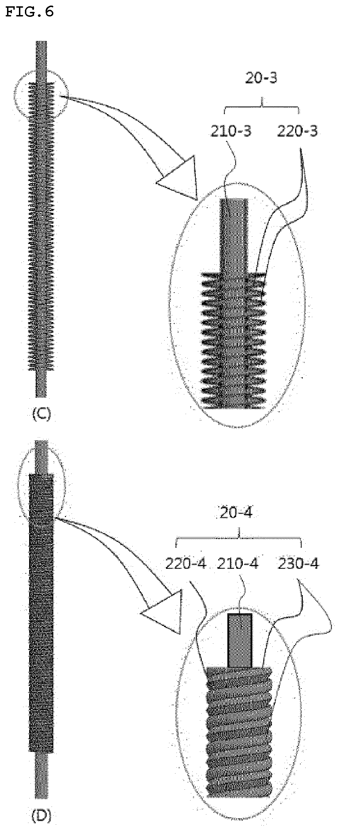

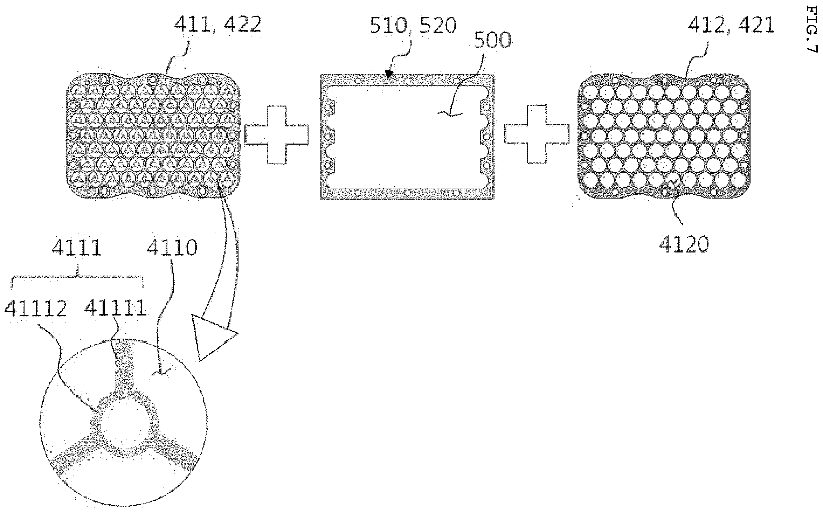

FIG. 2 is a perspective view of the overall appearance of a hydrogen activation/ionization accelerating apparatus having the ionization unit repeating arrangement structure of FIG. 1. FIG. 3 is an exploded perspective view of the entire system of a hydrogen activation/ionization accelerating apparatus having the ionization unit repeating arrangement structure of FIG. 2. FIG. 4 is a drawing showing the first to fourth type ionization units of various sharp vortex shapes of FIG. 3. FIGS. 5 and 6 are drawings that specifically enlarge the first to fourth type ionization units shown in Figure 4. FIG. 7 is a drawing showing the second anode plate, the second gasket unit, and the second cathode plate of FIG. 1.

The hydrogen activation/ionization accelerating apparatus (1) having an ionization unit repeating arrangement structure comprises a case (10), an ionization rod (20), an ionization cylinder (30), a brass fixing unit (40), and a gasket unit (50). In addition, the hydrogen activation/ionization accelerating apparatus (1) having an ionization unit repeating arrangement structure may further comprise an auxiliary battery (11). Here, the case (10) accommodates the ionization rod (20), the ionization cylinder (30), the brass fixing unit (40), and the gasket unit (50) therein. This case (10) becomes a passage through which hydrogen supplied through the hydrogen supply device (A) moves to the hydrogen fuel cell (B). The case (10) like this can be composed of a cover unit (110) with an accommodation space (100) formed inside and a body unit (120) with an accommodation space (100) formed inside and connected to the cover unit (110).

Such a cover unit 110 and a body unit 120 may be formed as shown in FIG. 2 . Additionally, a cylindrical gas inlet tube 111 may be formed at one end of the cover unit 110, and a cylindrical gas discharge tube 121 for discharging activated/ionized hydrogen may be formed at the other end of the body unit 120. At this time, the inlet screw module 1111 is installed in the gas inlet tube 111 of the cover 110 so that the hydrogen supplied from the hydrogen supply device (A) can be smoothly injected into the accommodation space inside the case 10. The inlet screw module 1111 can be a module of various shapes with blades formed in a spiral shape.

When a direct current voltage is applied from an external power supply, the ionization rod 20 and the ionization cylinder 30 form a high-density electric field flux between the two. At this time, the ionization rod 20 is connected to the positive electrode of an external power supply device through the first anode plate 412 or the second anode plate 422, and the ionization cylinder 30 is connected to the negative electrode of the external power supply device through the first cathode plate 411 or the second cathode plate 421, and an electric field is formed between the ionization rod 20 and the ionization cylinder 30.

Here, a plurality of ionization rods 20 and ionization cylinders 30 may be formed and fixed to the brass fixing unit 40.

A plurality of ionization rods (20) include a support (210) and a sharp metal (220) formed on an outer surface of the support (210). The plurality of ionization rods (20) are connected to a brass fixing unit (40) and connected to an external power supply device. Here, the sharp metal (220) may be formed in a structure in which a plurality of pins (221) or screw threads (220-2) are arranged in a spiral shape from one end to the other on the outer surface of the support module (210). In addition, the sharp metal may be formed in a structure in which a copper wire is twisted around the grooves of a plurality of thin plates or spiral screw threads (220-4). That is, the ionization rod (20) can be formed of a first type ionization rod part (20-1), a second type ionization rod part (20-2), a third type ionization rod part (20-3), and a fourth type ionization rod part (20-4), etc., of different types, as illustrated in FIG. 4, wherein the sharp metal (220) are formed. Here, the first type ionization rod (20-1) is formed of a structure including a support (210) in which the first rod (211) and the second rod (212) are twisted with each other, as illustrated in FIG. 5 (A), and a sharp metal in which a plurality of brush type pins (220-1) are formed in a spiral shape protruding from the outer surface of the support (210). The second type ionization rod (20-2) includes a cylindrical support (210-2) and a structure in which a spiral screw thread (220-2) is formed on the outer surface of the support (210-2) as shown in (B) of FIG. 5. The third type ionization rod (20-3) includes a cylindrical support (210-3) and a structure in which a thin plate is attached in a spiral shape to the outer surface of the support (210-3), as shown in (C) of FIG. 6. The fourth type ionization rod (20-4), as shown in (D) of FIG. 6, includes a cylindrical support (210-4), a spiral screw thread (220-4) on the outer surface of the support module (210-4), and a copper wire (230-4) inserted between a plurality of screw threads (220-4).

A plurality of ionization cylinders (30) are formed in a cylindrical shape and accommodate ionization rods (20) inside. These plurality of ionization cylinders (30) are connected to a brass fixing unit (40) and connected to the external power supply device.

A plurality of ionization cylinders (30) are connected to the negative electrode of the external power supply, and form an electric field between a plurality of ionization rods (20) connected to the positive electrode of the external power supply, ionize hydrogen introduced from the hydrogen supply device (A), and increase the activation energy of the hydrogen. The process of cationizing hydrogen through the electric field flux formed between the ionization rod (20) and the ionization cylinder (30) will be described in detail later.

The brass fixing unit (40) fixes the plurality of ionization rods (20) and the plurality of ionization cylinders (30), and is connected to the external power supply to apply electricity to the plurality of ionization rods (20) and the plurality of ionization cylinders (30). The brass fixing unit (40) comprises a first brass fixing unit (410) and a second brass fixing unit (420). Here, the first brass fixing unit (410) includes the first anode plate (412) and the first cathode plate (411) and is located on one side of the case (10), and the second brass fixing unit (420) includes a second anode plate module (422) and a second cathode plate module (421) and is located on the other side of the case unit (10). Here, the first anode plate (412) includes a plurality of rod fixing holes (4110) to fix one end of the support (210) protruding outwardly from one end of the ionization cylinder. And the second anode plate module (422) includes a plurality of rod fixing holes (4110) to fix the other end of the support (210) protruding outwardly from the other end of the ionization cylinder. At this time, the first anode plate (412) and the second anode plate (422) may include a rod fixing body (4111) installed in one rod fixing hole (4110), that is, a rod fixing body (4111) composed of one ring installed inside the rod fixing hole and three rods, as shown in FIG. 7.

The first anode plate (412) and the second anode plate (422) can accommodate one end of the ionization rod and the other end of the ionization rod in the formed ring of the rod fixing body (4111) so that the ionization rod can be fixed. In addition, the ionization rod (20) can be made to have a bipolar shape by being connected to the positive electrode of an external power supply.

The first cathode plate (411) includes a plurality of cylinder fixing holes (4120) and fixes one end of the ionization cylinder. The second cathode plate (421) includes a plurality of cylinder fixing holes (4120) and fixes the other end of the ionization cylinder. The first cathode plate (411) and the second cathode plate (421) can be connected to a negative electrode of an external power supply so that the ionization cylinder (30) has a negative polarity. The first anode plate (412) and the first cathode plate (411) or the second anode plate module (422) and the second cathode plate module (421) can be connected to the auxiliary battery unit (11). For example, the auxiliary battery unit (11) has one end connected to the first anode plate (412) and the other end connected to the first cathode plate (411), and can be charged with electricity applied through the first anode plate (412) and the first cathode plate (411).

A brass fixing unit (40) like this is connected to an auxiliary battery unit (11) and can charge the auxiliary battery unit (11).

The gasket unit (50) seals the case (10) so that hydrogen that has flowed into the gas inlet tube (111) of the case (10) from the hydrogen supply device (A) does not leak back into the gas inlet tube (111). The gasket unit (50) can seal one end of the case (10) and the other end of the case (10) including the first gasket unit (510) and the second gasket unit (510). Here, the first gasket unit (510) and the second gasket unit (520) are formed in a structure in which a receiving hole (500) is formed inside. At this time, the first gasket unit (510) can receive one end of a plurality of supports (210) and be interposed between the first anode plate (412) and the first cathode plate (411). And the second gasket unit (520) can accommodate the other end of a plurality of supports (210) and be interposed between the second anode plate (422) and the second cathode plate (421). The gasket unit (50) can be firmly fixed to the brass fixing unit (40) by the bolt unit (60).

The bolt unit (60) may be a commonly used bolt. Such a bolt unit (60) is fastened with a nut unit (70). Here, the bolt unit (60) includes a first bolt (610) and a second bolt (620), and the nut unit (70) includes a first nut (710) and a second nut (780).

The first bolt (610) connects the first anode plate (412), the first cathode plate (411), and the first gasket unit (510) and is fastened with the first nut (710). Thus, the first anode plate (412), the first cathode plate (411), and the first gasket unit (510) can be formed as a single entity. The second bolt (620) connects the second anode plate (422), the second cathode plate module (421), and the second gasket unit (520) and is fastened with the second nut (720). Thus, the second anode plate (422), the second cathode plate (421), and the second gasket unit (520) can be formed as a single entity. The cathode and anode are combined in a completely separate manner to avoid electrical shorts.

The cylinder fixing unit (80) binds together a plurality of ionization cylinders (30) inserted into the first anode plate (412), the first cathode plate (411), and the first gasket unit (510) or the second anode plate (422), the second cathode plate (421), and the second gasket unit (520) so that the plurality of ionization cylinders (30) do not shake. This cylinder fixing unit (80) includes a first cylinder fixing unit (810) that binds together a plurality of ionization cylinders (30) on one side and a second cylinder fixing unit (820) that binds together on the other side. At this time, the first cylinder fixing unit (810) and the second cylinder fixing unit (820) can be formed in a shape as shown in FIG. 3.

A cylinder fixing unit (80) like this can be fixed to the ionization cylinder (30) via a cylinder fixing bolt unit (90). The cylinder fixing bolt unit (90) includes a first cylinder fixing bolt (910) fixed to the first cylinder fixing unit (810) and a second cylinder fixing bolt (920) fixed to the second cylinder fixing unit (820).

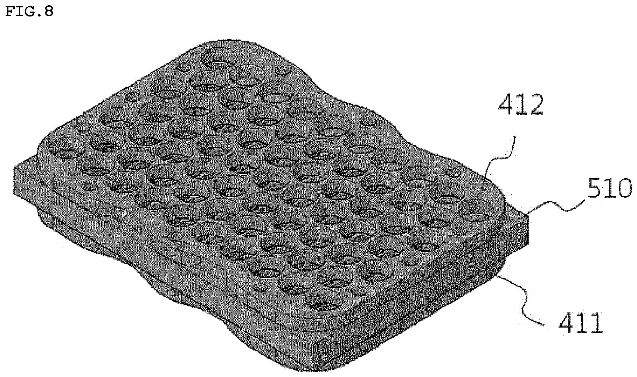

Hereinafter, with reference to FIGS. 8 to 17, the coupling relationship between components constituting a hydrogen activation/ionization accelerating apparatus having an ionization unit repeating arrangement structure will be specifically described.

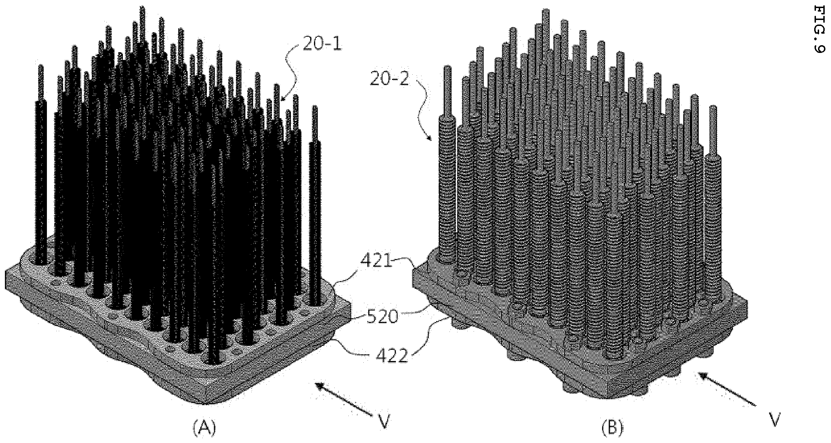

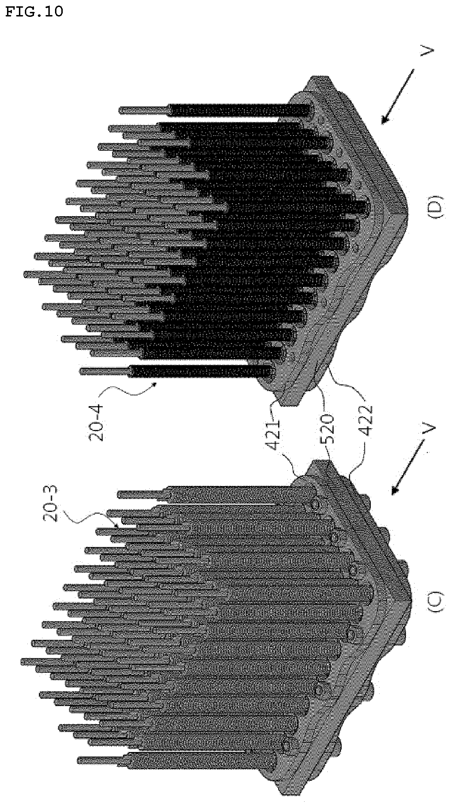

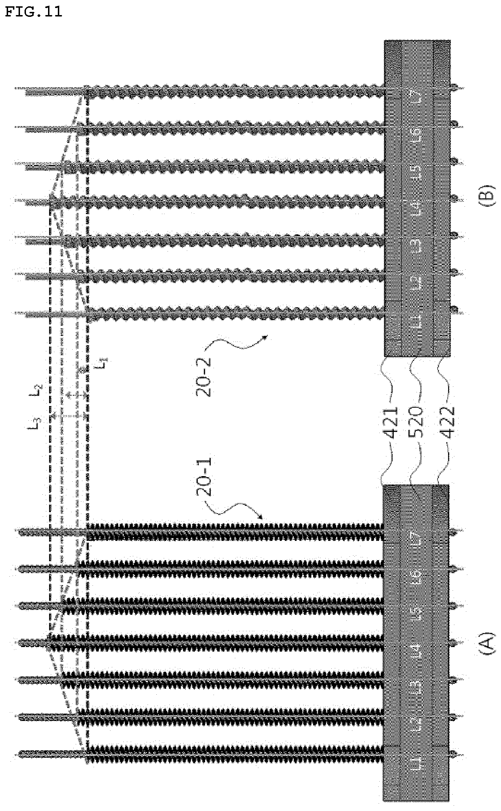

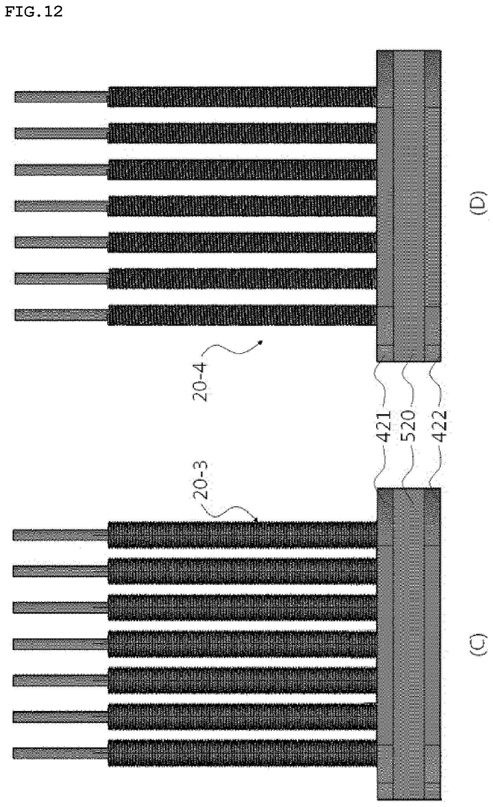

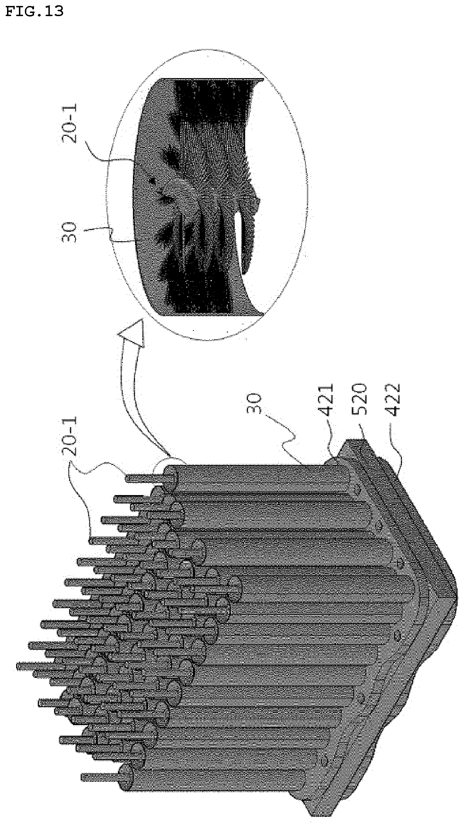

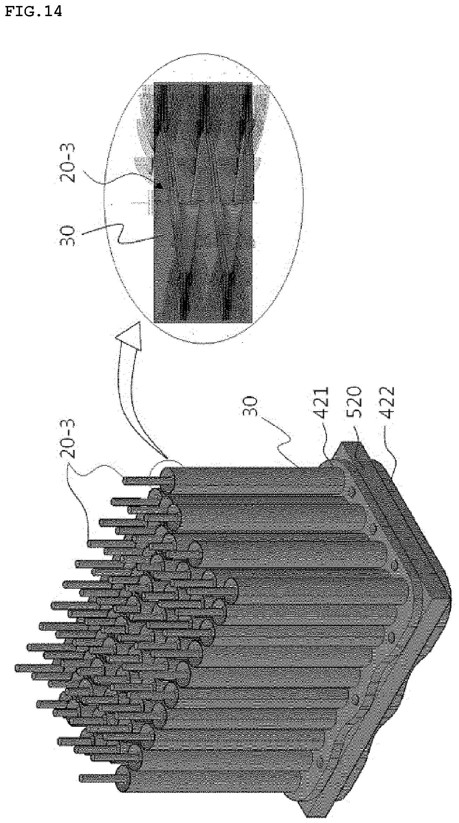

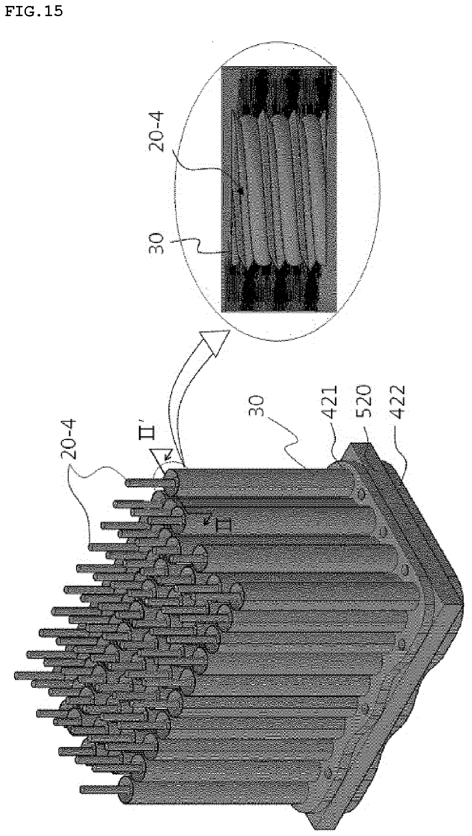

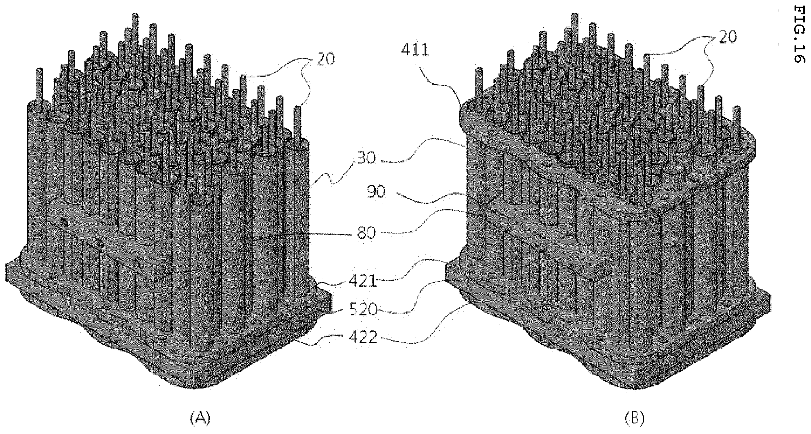

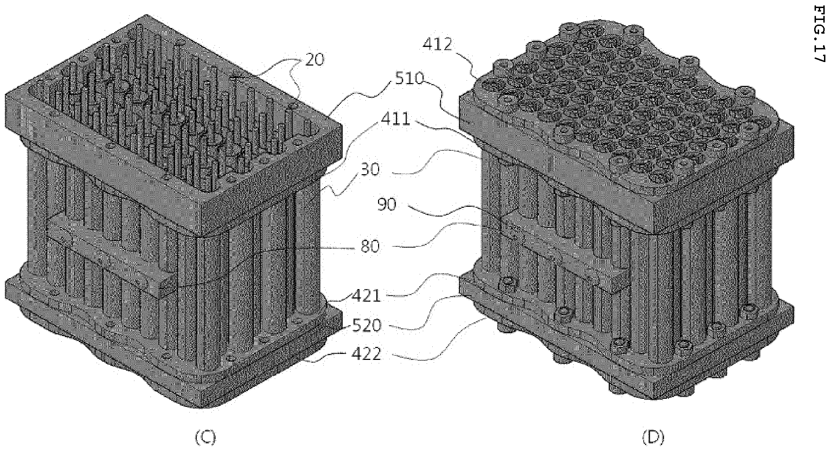

FIG. 8 is a drawing showing a state in which the second anode plate, the second gasket unit, and the second cathode plate of FIG. 7 are combined, and FIGS. 9 and 10 are drawings showing a state in which the first type of ionization rod, the second type of ionization rod, the third type of ionization rod, and the fourth type of ionization rod are fixed to the second anode plate, the second gasket unit, and the second cathode plate, and FIGS. 11 and 12 are drawings showing the structures shown in FIGS. 9 and 10 as viewed from the right. In addition, FIG. 13 is a drawing showing a state in which the first type of ionization rod and the ionization cylinder are fixed to the brass fixing unit and the gasket unit, and FIG. 14 is a drawing showing a state in which the third type of ionization rod and the ionization cylinder are fixed to the brass fixing unit and the gasket unit. And Fig. 15 is a drawing showing a state where the 4th type ionization rod and ionization cylinder are fixed to the brass fixing unit and the gasket unit, and the electric field flux emitted from the round copper wire focuses the electric field flux formed at the sharp surface into a higher-density electric field flux, thereby helping to form an ultra-high density. Fig. 16 is a drawing showing a state where the 1st type ionization rod and ionization cylinder are fixed to the second anode plate, the second gasket unit, and the second cathode plate of Fig. 8, and the cylinder fixing unit is fixed to the ionization cylinder. And Fig. 17 is a drawing showing a state where the first gasket unit is connected to Fig. 16, and the first anode plate is connected.

As shown in Fig. 8, a second cathode plate (421), a second gasket unit (520) thereon, and a second cathode plate module (422) thereon are stacked and can be fixed through the second bolt (620) and second nut (710) described above.

The other end of the ionization rod (20) and the other end of the ionization cylinder (30) are fixed to the second anode plate (422), the second gasket unit (520), and the second cathode plate (421) which are fixed with the second bolt (620) and the second nut (710) .

First, as shown in (A) of FIG. 9, a first type ionization rod (20-1) may be installed on the second anode plate (422), the second gasket unit (520), and the second cathode plate (421) fixed with the second bolt (620) and the second nut (720). And as shown in (B) of FIG. 9, a second type ionization rod (20-2) may be installed. And as shown in (C) of FIG. 10, a third type ionization rod (20-3) may be installed, and as shown in (D) of FIG. 10, a fourth type ionization rod (20-4) may be installed.

When the structure of FIG. 9 and FIG. 10 is viewed from the right side, it can have a shape as shown in (A) and (B) of FIG. 11. At this time, a plurality of ionization rods (20) can be installed in seven rows on the second anode plate (422), the second gasket unit (520), and the second cathode plate (421). Here, the number of cathode plates can vary depending on the size.

Here, the plurality of ionization rods (20) may be ionization rods (20) of the first to seventh rows. At this time, the height of the sharp metal (220) may gradually increase from the ionization rod of the first row to the ionization rod of the fourth row, and the height of the sharp metal (220) may gradually decrease from the ionization rod of the fourth row to the ionization rod of the seventh row. The reason why the height of the sharp metal of the ionization rods of the first to seventh rows is symmetrical with respect to the sharp metal of the ionization rod of the fourth row is to ensure that the hydrogen supplied from the hydrogen supply device (A) is ionized between the plurality of ionization rods (20) and the plurality of ionization cylinders (30) after diffusing outward. In addition, (A) and (B) of FIG. 9 may have shapes as illustrated in (C) and (D) of FIG. 10. At this time, multiple ionization rods (20) can be installed in seven rows at the same height on the second anode plate (422), the second gasket unit (520), and the second cathode plate (421).

The drawings shown in FIGS. 11 to 13 are drawings showing a structure in which an ionization cylinder is inserted into the structure shown in FIG. 7 (A), the structure shown in FIG. 8 (A), and the structure shown in FIG. 8 (B).

First, as shown in FIG. 11, when the ionization cylinder and the first type ionization rod (20-1) are cut along the line II-II', the ionization cylinder (30) and the first type ionization rod (20-1) can exhibit a structure as shown in the enlarged view on the left. And a high-density electric field flux can be formed. And as shown in FIG. 12, when the ionization cylinder and the second type ionization rod (20-2) are cut along the line II-II', the ionization cylinder (30) and the second type ionization rod (20-2) can exhibit a structure as shown in the enlarged view on the left. And an electric field can be formed. And as shown in Fig. 12, when the ionization cylinder and the second type ionization rod (20-2) are cut along the line II-II', the ionization cylinder (30) and the second type ionization rod (20-2) can exhibit a structure as shown in the enlarged view on the left. At this time, when electricity is applied to the first anode plate (412) and the first cathode plate (411) or the second anode plate (422) and the second cathode plate (421), an electric field can be formed between the plurality of ionization rods (20) and the plurality of ionization cylinders (30) .

As shown in (A) of FIG. 16, when the ionization cylinder (30) and the ionization rod (20) are inserted into the second anode plate (422), the second gasket unit (520), and the second cathode plate (421), a cylinder fixing unit (80) can be installed on the ionization cylinder (30) and the ionization rod (20). And as shown in (B) of FIG. 16, a cylinder fixing bolt unit (90) can be installed on the cylinder fixing unit (80). And a first cathode plate (411) can be inserted into one end of the ionization cylinder (30).

Thereafter, as shown in (A) of FIG. 17, a first gasket unit (510) may be installed on the first cathode plate (411). Then, a first anode plate (412) may be placed on the first gasket unit (510). Thereafter, the first anode plate module (412), the first gasket unit (510), and the first cathode plate (411) may be connected by a first bolt (610) and a first nut (710).

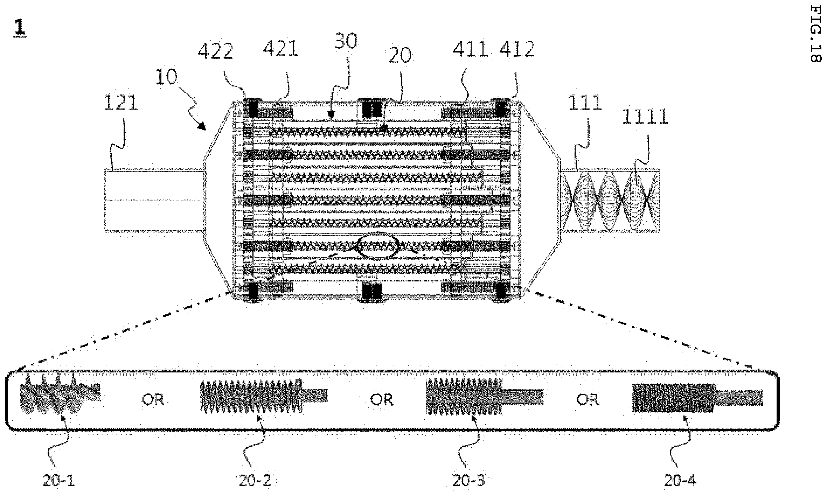

Hereinafter, with reference to FIGS. 18 to 24, the state in which the hydrogen activation/ionization accelerating apparatus having the ionization unit repeating arrangement structure of the present invention positively and negatively ionizes hydrogen and the process of charging the auxiliary battery unit from the process of ionizing hydrogen will be specifically described.

FIG. 18 is a cross-sectional view taken along line I-I' of a hydrogen activation/ionization accelerating apparatus having an ionization unit repeating arrangement structure according to an embodiment of the present invention of FIG. 2, and FIGS. 19 to 24 are drawings showing a state in which hydrogen is ionized in a hydrogen activation/ionization accelerating apparatus having the ionization unit repeating arrangement structure.

When the hydrogen activation/ionization accelerating apparatus (1) having the ionization unit repeating arrangement structure shown in Fig. 2 is cut along the line I-I', a structure as shown in Fig. 18 can be obtained.

Here, the hydrogen activation/ionization accelerating apparatus (1) having an ionization unit repeating arrangement structure may include any one of a first type ionization rod (20-1), a second type ionization rod (20-2), a third type ionization rod (20-3), or a fourth type ionization rod (20-4).

Hereinafter, in order to simplify the description of the operation of a hydrogen activation/ionization accelerating apparatus (1) having an ionization unit repeating arrangement structure, the operation of the apparatus (1) will be specifically described using a hydrogen activation/ionization accelerating apparatus (1) having an ionization unit repeating arrangement structure including a first type ionization rod (20-1) as an example.

In a hydrogen activation/ionization accelerating apparatus (1) having an ionization unit repeating arrangement structure, electricity is applied to a brass fixing unit (40) through the external power supply (C), and hydrogen is injected through a hydrogen supply device (A). At this time, the inlet screw module (1111) rotates to diffuse the hydrogen injected from the hydrogen supply device (A) and widely spread it into the accommodation space (100) of the case (10). In addition, an electric field flux having a high-density electric force line can be formed between a plurality of ionization rods (20) to which electricity is applied and a plurality of ionization cylinders (30).

At this time, as illustrated in FIG. 20, a positive electric field is generated in the ionization rod (20), and a negative electric field is generated in the ionization cylinder (30). Here, the positive electric field easily excites the hydrogen molecule (H₂) by overcoming the nuclear force with which electrons are combined, and the negative electric field forms a repulsive force with the shared electrons of the hydrogen molecule (H₂), thereby quickly exciting the hydrogen molecule by repelling the shared electrons from the hydrogen molecule. At this time, the excited hydrogen moves to the multiple pins of the ionization rod (20) connected to the positive electrode. At this time, the excited hydrogen that has moved to the multiple pins of the support (210) connected to the positive electrode is easily cationized (2H⁺) by having its electrons stolen by the multiple pins. Here, the cationized hydrogen (Proton) quickly moves to the ionization cylinder (30) connected to the negative electrode by the strong repulsive force of the positive electric field and the strong attractive force of the negative electric field. And the cationized hydrogen (2H⁺) that has moved to the ionization cylinder (30) connected to the negative electrode is transformed into hydrogen molecules (H₂), i.e., neutral hydrogen, as electrons (e⁻) are quickly absorbed. Thereafter, the transformed hydrogen molecules (H₂) move again to the ionization rod (20) connected to the positive electrode and are cationized, and the cationized hydrogen moves again to the ionization cylinder (30) connected to the negative electrode and is transformed into neutral hydrogen (H₂) .

That is, the hydrogen supplied from the hydrogen supply device (A) goes through the above process continuously, that is, the excited state, the ionized state, and then the neutralized state. At this time, when the hydrogen goes through this process, the excited energy increases.

As shown in FIG. 21, a plurality of ionization rods (20) and a plurality of ionization cylinders (30) transform hydrogen gas (H₂) supplied from the hydrogen supply device (A) into Excited State (H₂*) → Ionized (2H⁺+2e) → Neutralized (H₂) in a strong negative/positive electric field, while extracting electrons (Field Emission Electron). And, as shown in FIGS. 22 and 23, the electrons extracted from the hydrogen move to the auxiliary battery unit (11) and charge the auxiliary battery unit (11).

Here, the Excited State(H₂*) refers to hydrogen in a state where the activation energy is high due to the attraction/repulsion of the electric field, and which can be easily ionized. This hydrogen becomes the fuel that increases the efficiency of electricity generation of hydrogen fuel cells. Ionized(2H⁺) refers to Proton (2H⁺) hydrogen in which electrons are released by the positive electric field and move to the cathode by electrostatic force. And Neutralized(H₂) is hydrogen formed when the Proton (2H⁺) that moved to the cathode absorbs two electrons by the high-density positive electric field.

In this way, the present invention improves the performance of a hydrogen fuel cell (B) by transforming hydrogen gas into various states such as H₂, 2H⁺, and H₂* through a high-density electric field of the negative/positive electrodes. In addition, by transforming hydrogen gas, a large amount of electricity is generated and stored for later use.

It can exhibit high driving efficiency by applying it to the ionization rod (20) and the ionization cylinder (30).

Although the embodiments of the present invention have been described with reference to the attached drawings, those skilled in the art will understand that the present invention can be implemented in other specific forms without changing the technical idea or essential features thereof. Therefore, it should be understood that the embodiments described above are exemplary in all respects and not restrictive.

### [Description of Reference Numerals]

| | | | |
|---|---|---|---|
| 1: | Hydrogen activation/ionization accelerating having an ionization unit repeating arrangement structure | | |
| 10: | Case | 11: | Auxiliary battery section |
| 100: | Accommodation space | | |
| 110: | Cover unit | 120: | Body unit |
| 111: | Gas inlet tube | 121: | Gas discharge tube |
| 1111: | Inlet screw module | | |
| 20: | Ionization rod | | |
| 20-1: | Type 1 ionization rod | 20-2: | Type 2 ionization rod |
| 20-3: | Type 3 ionization rod | 20-4: | Type 4 ionization rod |
| 210: | Support | | |
| 211: | Type 1 rod | 212: | Type 2 rod |
| 220: | Sharp metal | | |
| 221: | Pin | | |
| 30: | Ionization cylinder | | |
| 40: | Brass fixing unit | | |
| 410: | Type 1 brass fixing unit | 412: | First anode plate |
| 4110: | Rod fixing hole | 4111: | Rod fixing body |
| 411: | First cathode plate | | |
| 4120: | Cylinder fixing hole | | |
| 420: | Second brass fixing unit | | |
| 421: | Second cathode plate | 422: | Second anode plate |
| 50: | Gasket unit | 500: | Receiving hole |
| 510: | First gasket unit | 520: | Second gasket unit |
| 60: | Bolt unit | | |
| 610: | First bolt | 620: | Second bolt |
| 70: | Nut part | | |
| 710: | First nut | 720: | Second nut |
| 80: | Cylinder fixing unit | | |
| 810: | First cylinder fixing unit | 820: | Second cylinder fixing unit |
| 90: | Cylinder fixing bolt unit | | |
| 910: | First cylinder fixing bolt | 920: | Second cylinder fixing bolt |
| A: | Hydrogen supply device | B: | Hydrogen fuel cell |
| C: | External power supply device | | |

## Claims

1. A hydrogen activation/ionization accelerating apparatus having an ionization unit repeating arrangement structure, installed between a hydrogen supply device (A) and a hydrogen fuel cell (B), the apparatus comprising:
a case (10) in which an accommodation space (100) is formed inside, a gas inlet tube (111) is formed at one end to be connected to the accommodation space (100) and a hydrogen supply device (A), and a gas discharge tube (121) is formed at the other end to be connected to the accommodation space (100) and a hydrogen fuel cell (B) ;
ionization rods (20) comprising a support (210) and a sharp metal (220) formed on the outer surface of the support (210);
ionization cylinders (30) formed in a cylindrical shape and accommodating ionization rod parts (20) inside;
a brass fixing unit (40) comprising:
a first anode plate (412) that comprises a plurality of rod fixing holes (4110), fixes one end of the support (210) protruding outward from one end of the ionization cylinder portion, and is connected to the positive electrode of the power supply so that the ionization rod portion (20) has a bipolar shape, and
a first cathode plate (411) that comprises a plurality of cylinder fixing holes (4120), and fixes one end of an ionization cylinder (30) to each cylinder fixing hole (4120) and is connected to a negative electrode of a power supply so that the ionization cylinder (30) has a negative polarity; and
a gasket unit (50) comprising a receiving hole (500) formed inside and interposed between the first anode plate (412) and the first cathode plate (411).

2. The apparatus of claim 1, wherein the brass fixing unit (40) further comprises:
a second anode plate (422) that fixes the other end of the support (210) protruding outward from the other end of the ionization cylinder, and
a second cathode plate (421) that comprises a plurality of cylinder fixing holes (4120) and fixes the other end of the ionization cylinder (30) to each of the cylinder fixing holes (4120).

3. The apparatus of claim 1, which is connected to an auxiliary battery unit (11) that is connected at one end to the first anode plate (412) and at the other end to the first cathode plate (411), and is charged with electricity supplied through the first anode plate (412) and the first cathode plate (411).

4. The apparatus of claim 1, wherein the case (10) comprises:
a cover unit (110) comprising the gas inlet tube (111) with an inlet screw module (1111) installed inside, and
a body unit (120) in which the gas discharge tube (121) is formed.
